**Europäisches Patentamt**

**European Patent Office**

**Office européen des brevets**

(19)

(11) Veröffentlichungsnummer : **0 043 510**
**B1**

(12)
# EUROPÄISCHE PATENTSCHRIFT

(45) Veröffentlichungstag der Patentschrift :
26.09.84

(51) Int. Cl.³ : **H 02 M 1/08**

(21) Anmeldenummer : **81104932.9**

(22) Anmeldetag : **25.06.81**

(54) Schaltungsanordnung zum speisespannungssynchronisierten Schalten von Spannungshalbwellen.

(30) Priorität : **08.07.80 DE 3025857**

(43) Veröffentlichungstag der Anmeldung :
**13.01.82 Patentblatt 82/02**

(45) Bekanntmachung des Hinweises auf die Patenterteilung : **26.09.84 Patentblatt 84/39**

(84) Benannte Vertragsstaaten :
**AT CH DE FR GB IT LI SE**

(56) Entgegenhaltungen :
**DE-A- 1 638 426**
**DE-A- 2 110 713**
**DE-A- 2 459 016**
**FR-A- 2 326 799**
**US-A- 4 021 683**

(73) Patentinhaber : **Siemens Aktiengesellschaft**
**Berlin und München Wittelsbacherplatz 2**
**D-8000 München 2 (DE)**

(72) Erfinder : **Schmidt, Helmut**
**Am Europakanal 4**
**D-8520 Erlangen (DE)**

# Beschreibung

Die Erfindung betrifft eine Schaltungsanordnung zum speisespannungssynchronisierten Schalten jeder zweiten Spannungshalbwelle einer Wechselspannung mit einem steuerbaren Halbleiterschaltelement, das in Serie mit der Last mit der Wechselspannungsquelle verbunden ist, und mit einem Steuerkreis, der eine Impulsformerstufe und eingangsseitig und ausgangsseitig je eine Potentialtrennstufe enthält und dessen Eingang mit der Wechselspannungsquelle und dessen Ausgang mit einem Steuereingang des Halbleiterschaltelementes verbunden ist.

Eine solche Schaltungsanordnung ist in handelsüblichen Geräten vorhanden. Eine derartige Schaltung besteht aus einem antiparallelgeschalteten Thyristorpaar als steuerbarem Halbleiterschaltelement, das mit der Phase eines Wechselstromnetzes verbunden ist und in einem Schaltkreis liegt, und einem Steuerkreis zur netzsynchronisierten Ansteuerung des Thyristorpaares. Im Steuerkreis werden durch einen Netztransformator mit nachgeschaltetem Schmitt-Trigger als Impulsformerstufe rechteckförmige und von der Netzspannung potentialgetrennte Spannungsimpulse erzeugt, die durch einen nachgeschalteten Oszillator in schmale Kettenimpulse zerlegt werden. Eine anschließende Zählstufe läßt für eine vorgegebene Zeitspanne eine Anzahl von Impulsen passieren, die über einen nachgeschalteten Impulsübertrager zum Steuereingang des Thyristorpaares geführt werden. Solche Schaltungen werden beispielsweise zur Erzeugung eines pulsierenden Gleichstromes aus Drehstrom für die elektrische Bremsung von Drehstromasynchronmotoren verwendet. Diese Schaltung erfordert einen hohen Aufwand an Bauteilen. Insbesondere verursacht der Impulsübertrager beträchtliche Kosten, da er für den Fall nicht gezündeter Thyristoren für hohe anliegende Spannungen ausgelegt sein muß und an seine Übertragungseigenschaften hohe Anforderungen gestellt werden.

Der Erfindung liegt die Aufgabe zugrunde, eine Schaltungsanordnung der eingangs genannten Art so auszubilden, daß sie eine einfache Potentialtrennung bei geringem Aufwand an Bauteilen aufweist.

Erfindungsgemäß wird diese Aufgabe dadurch gelöst, daß das Halbleiterschaltelement ein Halbleiterrelais ist, das mindestens ein steuerbares Halbleiterbauelement und ein erstes optoelektronisches Koppelelement als ausgangsseitige Potentialtrennstufe des Steuerkreises enthält und das in einem Bereich kleiner Spannungen bezogen auf den Scheitelwert der Spannung vom Nulldurchgang der Spannung an ansteuerbar ist, daß die eingangsseitige Potentialtrennstufe des Steuerkreises ein zweites optoelektronisches Koppelelement ist, und daß an den Eingang des Steuerkreises jede zweite Halbwelle einer aus der Wechselspannungsquelle abgeleiteten phasenverschobenen Wechselspannung gelegt ist.

Durch ein erstes zu einem Halbleiterrelais gehörendes optoelektronisches Koppelement und ein zweites optoelektronisches Koppelelement im Steuerkreis der Schaltungsanordnung wird zwischen Steuer- und Leistungskreis eine zweifache Potentialtrennung mit geringem Bauteilaufwand erzielt. Der Koppelfaktor, der Temperaturgang und Alterungserscheinungen der beiden Optokoppler im Steuerkreis haben keinen Einfluß auf die Wirkungsweise der Schaltungsanordnung. Für die Ansteuerung des Thyristorpaares zur Schaltung einer Spannungshalbwelle ist nicht wie bei der bekannten Anordnung eine Vielzahl von Steuersignalen, sondern nur noch ein Steuersignal erforderlich. Durch das phasenverschiebende Bauelement erhält das zweite optoelektronische Koppelelement eine Spannung, die beispielsweise um 90° el. gegenüber der vom Halbleiterrelais zu schaltenden Spannung phasenverschoben und synchron zu dieser ist. Dadurch erhält das zweite optoelektronische Koppelelement eine Wechselspannung, die etwa an denjenigen Stellen Maxima besitzt, an denen die von dem Halbleiterrelais zu schaltende Spannung Nulldurchgänge aufweist. Somit erzeugt das zweite optoelektronische Koppelelement netzsynchronisierte Spannungsimpulse, die symmetrisch zum Nulldurchgang der zu schaltenden Spannung liegen und den Spannungsbereich, in dem das Halbleiterrelais ansteuerbar ist, das sog. Zündfenster überdecken. Solche Halbleiterrelais, die im wesentlichen aus einem antiparallelgeschalteten Thyristorpaar oder Triac als Schaltelement und einem optoelektronischen Koppelelement zur Ansteuerung des Thyristorpaares bzw. des Triacs bestehen, sind in der Zeitschrift « Bauteile Report » 15 (1977), Heft 5, Seite 163 bis 167 und Heft 6, Seite 198 bis Seite 203 beschrieben. Halbleiterrelais werden auch als Solid-State-Relais oder elektronische Lastrelais bezeichnet.

Vorteilhaft ist es, daß die Phasenverschiebung dadurch realisiert ist, daß die Spannung zwischen einer Phase und einem Spannungsmittelpunkt einer dreiphasigen Wechselspannungsquelle an den Eingang des Steuerkreises gelegt ist, und daß zwischen die beiden anderen Phasen der Wechselspannungsquelle das Halbleiterrelais mit der Last geschaltet ist, weil dadurch eine Phasenverschiebung ohne zusätzliche Bauelemente besonders einfach möglich ist.

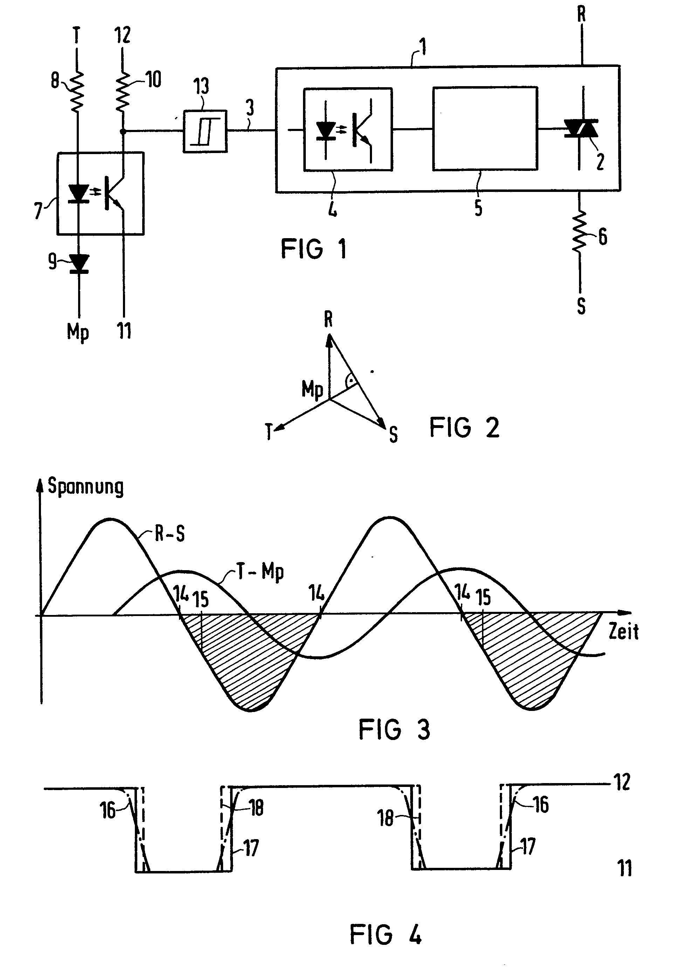

Die erfindungsgemäße Schaltungsanordnung wird im folgenden beispielhaft anhand der Figuren 1 bis 4 dargestellt und beschrieben. Die in den Figuren auftretenden gleichen Bauelemente und Größen sind mit gleichen Bezugszeichen versehen.

In Figur 1 ist die erfindungsgemäße Schaltungsanordnung zum speisespannungssynchronisierten Schalten von Spannungshalbwellen dargestellt. Die Schaltungsanordnung besteht aus einem Halbleiterrelais 1 als Halbleiterschaltelement, einem zweiten optoelektronischen Koppelelement 7 als Teil eines Steuerkreises und einem Schmitt-Trigger 13 als Impulsformerstufe des Steuerkreises. Die zu schaltende Wechselspannung und die Wechselspannung zur Erzeugung von Synchronisierimpulsen werden einem dreiphasigen Drehstrom-Betriebsnetz mit den Phasen R, S und T und dem Spannungsmittelpunkt Mp entnommen. Das Halbleiterrelais ist mit einer Last 6 verbunden. Der Schaltkreis aus dem Halbleiterrelais 1 und der Last 6 wird mit einer Wechselspannung versorgt, die von den Phasen R und S des Drehstrom-Betriebsnetzes geliefert wird. Das Halbleiterrelais 1 enthält zwei steuerbare Halbleiterbauelemente in Gestalt eines antiparallelgeschalteten Thyristorpaares 2. Das Halbleiterrelais 1 erhält über einen Steuereingang 3 ein Signal zur Ansteuerung des Thyristorpaares 2. Ein Steuersignal gelangt über ein im Halbleiterrelais 1 befindliches erstes optoelektronisches Koppelelement 4 und einen im Halbleiterrelais 1 befindlichen Nullpunktschalter 5 an den Zündeingang des Thyristorpaares 2. Die Erzeugung der netzsynchronisierten Spannungsimpulse zur Ansteuerung des Halbleiterrelais 1 erfolgt durch das zweite optoelektronische Koppelelement 7. Der Diodenkreis des zweiten Optokopplers 7 ist anodenseitig über einen Strombegrenzungswiderstand 8 mit der Phase T des Drehstrom-Betriebsnetzes verbunden. Kathodenseitig ist der Diodenkreis des zweiten Optokopplers 7 mit der Anode einer der Erhöhung der Spannungsfestigkeit dienenden Diode 9 verbunden. Die Kathode der Diode 9 ist mit dem Spannungsmittelpunkt Mp des Drehstrom-Betriebsnetzes verbunden. Der Fototransistor des Optokopplers 7 ist emitterseitig mit dem ersten Pol 11 und kollektorseitig über einen Strombegrenzungswiderstand 10 mit dem zweiten Pol 12 einer Hilfsgleichspannungsquelle verbunden. Zwischen dem Widerstand 10 und dem Kollektor des Fototransistors des zweiten Optokopplers 7 ist der Eingang des Schmitt-Triggers 13 angeschlossen. Der Ausgang des Schmitt-Triggers ist mit dem Steuereingang 3 des Halbleiterrelais 1 verbunden. Zum Steuerkreis der Schaltungsanordnung gehören das erste optoelektronische Koppelelement 4 im Halbleiterrelais 1, das zweite optoelektronische Koppelelement 7 und der Schmitt-Trigger 13.

Das Halbleiterrelais 1 ist üblicherweise mit einem Nullpunktschalter 5 ausgestattet, wodurch es in den Nulldurchgängen der zu schaltenden Wechselspannung R-S mit einer gewissen Öffnungsbreite durchschaltet. Das Halbleiterrelais 1 ist daher zwischen dem Nulldurchgang und einem gegenüber dem Scheitelwert der Spannung R-S kleinen, aus den technischen Daten für das Halbleiterrelais 1 entnehmbaren Spannungswert nach dem Nulldurchgang ansteuerbar. Das Halbleiterrelais 1 besitzt also im Bereich der Nulldurchgänge der zu schaltenden Spannung R-S jeweils ein Zündfenster. Für die Ansteuerung des Halbleiterrelais 1 zum Schalten von einzelnen Spannungshalbwellen sind Spannungsimpulse erforderlich, die an den Stellen der Nulldurchgänge der Spannung R-S im Bereich der Zündfenster liegen. Der zweite Optokoppler 7 erzeugt die netzsynchronisierten Spannungsimpulse für die Ansteuerung des Halbleiterrelais 1. Der zweite Optokoppler 7 wird an eine um 90° el. gegenüber der zu schaltenden Wechselspannung R-S phasenverschobene Wechselspannung T-Mp gelegt und erzeugt an den Stellen der Nulldurchgänge der Schaltspannung R-S maximale Synchronisiersignale. Die Phasenverschiebung der Spannung T-Mp gegenüber der Spannung R-S wird durch geeignete Wahl der Phasenanschlüsse des Drehstrom-Betriebsnetzes erreicht, die darin besteht, daß das Halbleiterrelais 1 zwischen zwei Phasen geschaltet ist und der zweite Optokoppler 7 mit der dritten Phase und dem Spannungsmittelpunkt Mp verbunden ist. Eine solche Phasenverschiebung kann auch bei Verwendung einer einphasigen Wechselspannungsquelle durch ein phasenverschiebendes Bauelement erreicht werden. Die beiden optoelektronischen Koppelelemente 4 und 7 sind Potentialtrennstufen, die den Zündeingang des Thyristorpaares 2 im Halbleiterrelais 1 vom Drehstrom-Betriebsnetz R, S, T, Mp galvanisch trennen und durch die die Spannungsimpulse zur Ansteuerung des Thyristorpaares 2 von den Wechselspannungen R-S und T-Mp potentialgetrennt sind. Der Steuerkreis und der Schaltkreis der Schaltungsanordnung sind damit potentialgetrennt. Die Synchronisierung der an den Zündeingang des Thyristorpaares 2 gelangenden Spannungsimpulse bezüglich des Drehstrom-Betriebsnetzes R, S, T, Mp ist dadurch gegeben, daß die zur Erzeugung der Spannungsimpulse verwendete, dem zweiten Optokoppler 7 zugeführte Spannung T-Mp direkt dem Drehstrom-Betriebsnetz entnommen wird und daß die vom zweiten Optokoppler 7 erzeugten Spannungsimpulse bis zum Erreichen des Zündeingangs des Thyristorpaares 2 in ihrer Phasenlage nicht verändert werden. Der dem zweiten Optokoppler 7 nachgeschaltete Schmitt-Trigger 13 ist eine Impulsformerstufe, in dem die vom zweiten Optokoppler 7 kommenden Spannungsimpulse zu rechteckförmigen Impulsen geformt werden.

In Figur 2, 3 und 4 sind die zu schaltende Wechselspannung, die Ausgangsspannung zur Erzeugung der netzsynchronisierten Spannungsimpulse und die netzsynchronisierten Spannungsimpulse in ihren Phasenlagen für den Fall dargestellt, daß mit der Schaltungsanordnung nach Figur 1 eine pulsierende Gleichspannung erzeugt wird. Dazu ist es erforderlich, daß jede zweite Halbwelle der Wechselspannung R-S, d. h. jede positive oder jede negative Halbwelle netzsynchronisiert geschaltet wird. In Figur 3 und 4 ist der Fall dargestellt, daß jede negative Halbwelle geschaltet wird.

In Figur 2 ist das Zeigerdiagramm für das Drehstrom-Betriebsnetz R, S, T, Mp dargestellt. Daraus ist zu erkennen, daß die Spannung T-Mp senkrecht auf der Spannung R-S steht und damit um 90° el. gegenüber der Spannung R-S phasenverschoben ist. Durch geeignete Wahl der Phasenanschlüsse wird damit erreicht, daß die zur Erzeugung von netzsynchronisierten Spannungsimpulsen dienende Spannung T-Mp gegenüber der zu schaltenden Spannung R-S um 90° el. phasenverschoben ist.

In Figur 3 ist der Verlauf der zu schaltenden Spannung R-S und der zur Erzeugung von netzsynchronisierten Spannungsimpulsen dienenden Spannung T-Mp dargestellt. Die beiden Spannungen sind sinusförmige Wechselspannungen und die Spannung T-Mp ist gegenüber der Spannung R-S um 90° el. phasenverschoben. Zur Erzeugung eines pulsierenden Gleichstromes werden nur die negativen Halbwellen der Spannung R-S durch die Schaltungsanordnung nach Figur 1 geschaltet. Das Zündfenster des Halbleiterrelais 1 befindet sich jeweils zwischen den Nulldurchgängen 14 der Spannung R-S und einem Spannungswert an der Stelle 15 nach dem Nulldurchgang 14. Der Spannungswert an der Stelle 15 ist klein gegenüber dem Scheitelwert der Spannung R-S. Da nur jede negative, in Figur 3 schraffiert dargestellte Halbwelle geschaltet wird, müssen Spannungsimpulse für jedes Zündfenster 14-15 des Halbleiterrelais 1 zur Schaltung der negativen Halbwellen bereitgestellt werden. Die Breite der netzsynchronisierten Spannungsimpulse zur Zündung des Halbleiterrelais 1 sollte mindestens der Breite des Zündfensters 14-15 entsprechen, um die sichere Zündung des Halbleiterrelais 1 zu gewährleisten.

In Figur 4 sind die netzsynchronisierten Spannungsimpulse zur Ansteuerung des Halbleiterrelais 1 dargestellt. Das zweite optoelektronische Koppelelement 7 (Figur 1), dessen Diodenkreis mit der Spannung T-Mp (Figur 3) versorgt wird, liefert durch seinen Fototransistor die strichpunktiert dargestellten Spannungsimpulse 16. Die Spannungsimpulse 16 liegen zwischen den Spannungswerten 11 und 12 der Hilfsgleichspannungsquelle des Fototransistors des zweiten Optokopplers 7. Die vom zweiten Optokoppler 7 kommenden Spannungsimpulse 16 werden im Schmitt-Trigger 13 (Figur 1) zu rechteckförmigen Spannungsimpulsen 17 geformt, die in Figur 4 in ausgezogener Form dargestellt sind. Da die Impulse 17 aus der gegenüber der Spannung R-S um 90° el. phasenverschobenen Spannung T-Mp erzeugt sind und auf ihrem Weg bis zum Steuereingang 3 des Halbleiterrelais 1 keine Phasenverschiebung erfahren, liegen die Impulse 17 symmetrisch zu den zu den Zündfenstern 14-15 gehörenden Nulldurchgängen 14 der zu schaltenden Spannung R-S (Figur 3). Die Breite der Spannungsimpulse 17 überdeckt vollständig jedes Zündfenster 14-15 des Halbleiterrelais 1. Da die Spannungsimpulse 17 symmetrisch zu den links von den negativen Spannungshalbwellen liegenden Nulldurchgängen 14 der Spannung R-S (Figur 3) liegen, besitzt jeder Spannungsimpuls 17 mindestens die doppelte Breite des Zündfensters 14-15 des Halbleiterrelais 1. Da jeder Spannungsimpuls 17 das gesamte Zündfenster 14-15 überdeckt, kann jede negative Halbwelle bereits im Nulldurchgang 14 geschaltet werden. Bei schlechter werdendem Koppelfaktor des zweiten Optokopplers 7 und durch Temperatureinflüsse auf den Optokoppler 7 kann die Breite der Spannungsimpulse 17 abnehmen, wodurch die schmäleren Impulse 18 entstehen, die in gestrichelter Form in Figur 4 dargestellt sind. Da sich das Halbleiterrelais 1 nur im Bereich des Zündfensters 14-15, also vom Spannungsnulldurchgang 14 an ansteuern läßt und dieser in der Mitte des aus dem zweiten Optokoppler 7 gewonnenen Steuersignals 17 liegt, haben der Koppelfaktor und der Temperaturgang des Optokopplers praktisch keinen Einfluß auf die Funktionsfähigkeit der Schaltung. Dadurch ist auch bei Alterung des Optokopplers 7 die Symmetrie der Spannungsimpulse 17 gegenüber den Nulldurchgängen 14 gewahrt. Die Breite jedes Steuerimpulses 17 kann über die Breite der zu ihrer Erzeugung dienenden Halbwelle der Spannung T-Mp nicht hinausgehen und damit nicht länger als 180° el. werden. Dadurch ist ein Ansteuern einer nicht gewünschten Spannungshalbwelle ausgeschlossen. Der Laststrom durch das Halbleiterrelais 1 fließt bei gezündetem Thyristorpaar 2 so lange, wie er über dem Haltestrom liegt, und wird unabhängig vom Nulldurchgang der Spannung immer im Nulldurchgang des Laststroms abgeschaltet. Das Thyristorpaar 2 ist erst dann gelöscht. Bei jeder weiteren im betrachteten Falle negativen Halbwelle wird das Halbleiterrelais 1 erneut durch einen netzsynchronisierten Spannungsimpuls 17 gezündet. Auf diese Weise wird eine Einweggleichrichtung zur Erzeugung eines pulsierenden Gleichstroms durch gezieltes Ansteuern des Halbleiterrelais 1 mit jeweils einem Steuersignal 17 zum Schalten einer Halbwelle realisiert.

**Ansprüche**

1. Schaltungsanordnung zum speisespannungssynchronisierten Schalten jeder zweiten Spannungshalbwelle einer Wechselspannung mit einem steuerbaren Halbleiterschaltelement (1), das in Serie mit der Last (6) mit der Wechselspannungsquelle (R, S) verbunden ist, und mit einem Steuerkreis, der eine Impulsformerstufe (13) und eingangsseitig und ausgangsseitig je eine Potentialtrennstufe (7, 4) enthält und dessen Eingang mit der Wechselspannungsquelle und dessen Ausgang mit einem Steuereingang des Halbleiterschaltelementes verbunden ist, dadurch gekennzeichnet, daß das Halbleiterschaltelement (1) ein Halbleiterrelais ist, das mindestens ein steuerbares Halbleiterbauelement (2) und ein erstes optoelektronisches Koppelelement (4) als ausgangsseitige Potentialtrennstufe des Steuerkreises enthält und das in einem Bereich kleiner Spannungen bezogen auf den Scheitelwert der Spannung vom Nulldurchgang (14) der Spannung (R, S) an ansteuerbar ist, daß die eingangsseitige Potentialtrennstufe des Steuerkreises ein zweites optoelektronisches Koppelelement (7) ist, und daß an den Eingang des Steuerkreises jede zweite Halbwelle einer aus der Wechselspannungsquelle abgeleiteten phasenverschobenen Wechselspannung gelegt ist.

2. Schaltungsanordnung nach Anspruch 1, dadurch gekennzeichnet, daß die Phasenverschiebung dadurch realisiert ist, daß die Spannung zwischen einer Phase (T) und einem Spannungsmittelpunkt (Mp) einer dreiphasigen Wechselspannungsquelle (R, S, T, Mp) an den Eingang des Steuerkreises gelegt ist, und daß zwischen die beiden anderen Phasen (R, S) der Wechselspannungsquelle das Halbleiterrelais (1) mit der Last (6) geschaltet ist.

## Claims

1. Circuit arrangement for the supply-voltage-synchronised switching of each second voltage half-wave of an alternating voltage with a controllable semi-conductor switching element (1) which is connected in series with the load (6) of the alternating voltage source (R, S), and with a control circuit which contains a pulse-shaping stage (13) and a respective potential-isolating stage (7, 4) on the input and output sides, and whose input is connected to the alternating voltage source and whose output is connected to a control input of the semi-conductor switching element, characterised in that the semi-conductor switching element (1) is a semi-conductor relay which contains at least one controllable semi-conductor component (2) and a first opto-electronic coupling element (4) as an output-side potential-isolating stage of the control circuit, and which can be controlled in a range of voltages which are small in relation to the peak value of the voltage, and which range extends from the zero passage (14) of the voltage (R, S), in that the input-side potential-isolating stage of the control circuit is a second opto-electronic coupling element (7), and in that each second half-wave of a phase-shifted alternating voltage derived from the alternating voltage source is applied at the input of the control circuit.

2. Circuit arrangement according to claim 1, characterised in that the phase shifting is carried out by means of the voltage, between a phase (T) and a mean voltage point (Mp) of a three-phase alternating voltage source (R, S, T, Mp), being applied at the input of the control circuit, and in that between the two other phases (R, S) of the alternating voltage source the semi-conductor relay (1) is connected to the load (6).

## Revendications

1. Montage pour commuter, en synchronisme avec la tension d'alimentation, chaque seconde alternance d'une tension alternative, comportant un élément de commutation à semi-conducteurs (1) pouvant être commandé, qui est relié en série avec la charge (6) à la source de tension alternative (R, S), et comportant un circuit de commande qui contient un étage (13) de mise en forme d'impulsions et, du côté entrée et du côté sortie, des étages respectifs de séparation de potentiel (7, 4) et dont l'entrée est reliée à la source de tension alternative de l'élément de commutation à semi-conducteurs et dont la sortie est reliée à l'entrée de commande de cet élément, caractérisé par le fait que l'élément de commutation à semi-conducteurs (1) est un relais à semi-conducteurs qui contient au moins un composant à semi-conducteurs (1) pouvant être commandé et un premier élément de couplage opto-électronique (4) en tant qu'étage de séparation de potentiel situé du côté sortie, du circuit de commande et qui peut être commandé dans une plage de tensions faibles par rapport à la valeur maximale de la tension à partir du point d'annulation (14) de la tension (R, S), que l'étage de séparation de potentiel, situé du côté entrée, du circuit de commande est un second élément de couplage opto-électronique (7) et que chaque seconde alternance d'une tension alternative déphasée, dérivée de la source de la tension alternative, est appliquée à l'entrée du circuit de commande.

2. Montage suivant la revendication 1, caractérisé par le fait que le déphasage est réalisé de telle manière que la tension entre une phase (R) et un point neutre de tension (Mp) d'une source de tension alternative triphasée (R, S, T, Mp) est appliquée à l'entrée du circuit de commande, et que le relais à semi-conducteurs (1) muni de la charge (6) est branché entre les deux autres phases (R, S) de la source de tension alternative.

FIG 1

FIG 2

FIG 3

FIG 4